# EUROPEAN PATENT APPLICATION

(11) **EP 3 961 696 A1**
(43) Date of publication of application: **02.03.2022**
(21) Application number: 21806126.5
(22) Date of filing: 13.05.2021
(51) Int. Cl.: H01L 23/36, B32B 27/00, B32B 27/18, C08K 3/013, C08K 7/06, C08L 101/00, H01L 23/373, H05K 7/20

(54) **THERMALLY CONDUCTIVE SHEET, METHOD FOR MANUFACTURING SAME, HEAT-DISSIPATING STRUCTURE, AND ELECTRONIC APPARATUS**

(30) Priority: 28.05.2020 JP 2020093403; 11.05.2021 JP 2021080421
(71) Applicant: Dexerials Corporation, Shimotsuke-shi, Tochigi 3230194 (JP)
(72) Inventor: MUKASA, Keisuke, Shimotsuke-shi, Tochigi 323-0194 (JP); KUBO, Yusuke, Shimotsuke-shi, Tochigi 323-0194 (JP); ARAMAKI, Keisuke, Shimotsuke-shi, Tochigi 323-0194 (JP)
(74) Representative: Graf von Stosch Patentanwaltsgesellschaft mbH
(86) International application number: PCT/JP2021/018208
(87) International publication number: WO 2021/241249

(57) **Abstract**

A thermal conductive sheet including cured product of resin composition containing carbon fiber, inorganic filler other than the carbon fiber, and binder resin, the sheet satisfying:
(1) tack force of sheet surface is 100gf or greater, determined when the sheet between release films is subjected to press processing at 0.5MPa for 30sec, and immediately after the films are peeled off, is indented by 50µm at 2mm/second with probe 5.1mm in diameter and the probe is pulled away at 10mm/sec; and
(2) (B/A)× 100≥80% is true, A denoting tack force(gf) of the sheet surface immediately after the films are peeled off subsequent to the press processing of (1) and B denoting tack force(gf) of the sheet surface when the sheet is indented by 50pm at 2mm/second with probe 5.1mm in diameter and the probe is pulled away at 10mm/second after exposure to atmosphere for 1 hour subsequent to the press processing.

## Description

### Technical Field

The present invention relates to a thermal conductive sheet and a method for producing the thermal conductive sheet, and a heat dissipation structure and an electronic device.

### Background Art

Hitherto, various cooling methods have been employed in semiconductor elements mounted on various electrical appliances such as personal computers and other devices, because accumulation of heat generated as a result of driving of the semiconductor elements may adversely affect driving of the semiconductor elements and peripheral devices.

As a method for cooling a device having semiconductor elements, there are known, for example, a method of mounting the device with a fan to cool the air in the device housing, and a method of mounting the semiconductor element to be cooled with a heat sink such as a heat dissipation fin and a heat dissipation plate. In the method where a heat sink is mounted on the aforementioned semiconductor element to perform cooling, a thermal conductive sheet is provided between the semiconductor element and the heat sink in order to efficiently dissipate heat in the semiconductor element.

One proposed example of such a thermal conductive sheet uses a cured product of a silicone resin as a binder component. In this thermal conductive sheet, in order to improve close adhesiveness to a heat generator and a heat dissipation member, an unreacted silicone resin is allowed to bleed out from the thermal conductive sheet via pressing, and the bled-out unreacted silicone resin is coated on their surfaces to impart tackiness thereto, to attempt to improve close adhesiveness (see, for example, PTL 1).

### Citation List

### Patent Literature

PTL 1: Japanese Patent No. 5752299

### Summary of Invention

### Technical Problem

However, the present inventors have found that the technique described in PTL 1 has the following problems. Specifically, although the tack property (tackiness) exhibited through bleeding is enough to fix the positions of parts at the time of mounting, it is not enough to be able to fix the thermal conductive sheet when the mounted parts are inverted. Also, exposure of the thermal conductive sheet to the air results in decrease in tack force over time, which causes misalignment when placing the thermal conductive sheet between the heat generator and the heat dissipation member.

The present invention solves the above existing problems in the art and aims to achieve the following object. Specifically, the present invention has an object to provide a thermal conductive sheet having enough tack property to resist motions at the time of mounting and a method for producing the thermal conductive sheet, and a heat dissipation structure and an electronic device.

### Solution to Problem

Means for solving the above problems are as follows.
<1> A thermal conductive sheet including
   a cured product of a resin composition containing a carbon fiber, an inorganic filler other than the carbon fiber, and a binder resin,
   wherein the thermal conductive sheet satisfies (1) and (2) below:
      (1) a tack force of a surface of the thermal conductive sheet is 100 gf or greater, where the tack force is determined when the thermal conductive sheet held between release films is subjected to a press processing at 0.5 MPa for 30 seconds, and immediately after the release films are peeled off, the thermal conductive sheet is indented by 50 pm at 2 mm/second with a probe having a diameter of 5.1 mm and the probe is pulled away at 10 mm/second; and
      (2) (B/A)×100≥80% is true, where A denotes a tack force (gf) of the surface of the thermal conductive sheet immediately after the release films are peeled off subsequent to the press processing of the (1) and B denotes a tack force (gf) of the surface of the thermal conductive sheet when the thermal conductive sheet is indented by 50 pm at 2 mm/second with a probe having a diameter of 5.1 mm and the probe is pulled away at 10 mm/second after exposure to atmosphere for 1 hour subsequent to the press processing of the thermal conductive sheet.
<2> The thermal conductive sheet according to <1> above, wherein the thermal conductive sheet further satisfies (3) the tack force of the surface of the thermal conductive sheet is 20 gf or lower, where the tack force is determined when immediately after a slice processing of the thermal conductive sheet, the thermal conductive sheet is indented by 50 pm at 2 mm/second with a probe having a diameter of 5.1 mm and the probe is pulled away at 10 mm/second.
<3> The thermal conductive sheet according to <1> or <2> above, wherein the thermal conductive sheet has a Shore OO hardness of 40 or more but 70 or less.
<4> The thermal conductive sheet according to any one of <1> to <3> above, wherein the inorganic filler other than the carbon fiber contains at least one selected from: aluminum oxide having a specific surface area of 1.4 m²/g or more; aluminum nitride having a specific surface area of 1.4 m²/g or more; and aluminum hydroxide.
<5> The thermal conductive sheet according to any one of <1> to <4> above, wherein the inorganic filler other than the carbon fiber contains: aluminum oxide or aluminum nitride; and aluminum hydroxide.
<6> The thermal conductive sheet according to <4> or <5> above, wherein the specific surface area of the aluminum oxide or the aluminum nitride is 1.4 m²/g or more but 3.3 m²/g or less.
<7> The thermal conductive sheet according to any one of <1> to <6> above, wherein the inorganic filler other than the carbon fiber has a volume average particle diameter of 0.4 pm or more but 2 pm or less.
<8> The thermal conductive sheet according to <7> above, wherein the inorganic filler other than the carbon fiber has a volume average particle diameter of 0.7 pm or more but 2 pm or less.
<9> The thermal conductive sheet according to any one of <1> to <8> above, wherein the binder resin is a silicone resin.
<10> A method for producing the thermal conductive sheet according to any one of <1> to <9> above, the method including:
   molding the resin composition into a predetermined shape, followed by curing, to obtain a molded body of the resin composition, where the resin composition contains the binder resin, the carbon fiber, and the inorganic filler other than the carbon fiber; and
   cutting the molded body into a sheet to obtain a molded body sheet.
<11> A heat dissipation structure including:
   a heat generator;
   the thermal conductive sheet according to any one of claims <1> to <9> above; and
   a heat dissipation member,
   the heat generator, the thermal conductive sheet, and the heat dissipation member being provided in an order mentioned.
<12> An electronic device including
   the heat dissipation structure according to <11> above.

### Advantageous Effects of Invention

The present invention can solve the above existing problems in the art and aim to achieve the above object. The present invention can provide a thermal conductive sheet having enough tack property to resist motions at the time of mounting and a method for producing the thermal conductive sheet, and a heat dissipation structure and an electronic device.

### Brief Description of Drawings

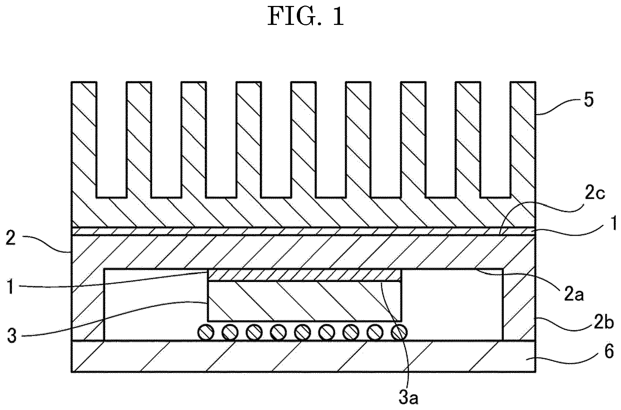

FIG. 1 is a schematic cross-sectional view illustrating one example of a heat dissipation structure of the present invention.

### Description of Embodiments

### (Thermal conductive sheet)

The thermal conductive sheet of the present invention is a cured product of a composition containing a carbon fiber, an inorganic filler other than the carbon fiber, and a binder resin.

The thermal conductive sheet of the present invention has both an oil bleed mechanism and a mechanism configured to retain bled-out oil on the sheet surface. With this structure, the surface of the thermal conductive sheet retains enough tack property for a long period of time. As a result, the thermal conductive sheet can be fixed to adhesion targets such as a heat generator and a heat dissipator. Even in excessive motions such as in an inverting step, it is possible to reduce the risk that the thermal conductive sheet will fall off.

In the present invention, the thermal conductive sheet satisfies the following (1) and (2) and preferably further satisfies the following (3). As a result, enough tack property is imparted to the surface of the thermal conductive sheet, which can be fixed to adhesion targets such as a heat generator and a heat dissipator without coming off even when mounted parts are inverted. It is possible to realize the thermal conductive sheet having enough tack property to resist motions at the time of mounting.
(1) The tack force of the surface of the thermal conductive sheet is 100 gf or greater, preferably 200 gf or greater, where the tack force is determined when the thermal conductive sheet held between release films is subjected to a press processing at 0.5 MPa for 30 seconds, and immediately after the release films are peeled off, the thermal conductive sheet is indented by 50 pm at 2 mm/second with a probe having a diameter of 5.1 mm and the probe is pulled away at 10 mm/second.
(2) The (B/A)×100≥80% is true, preferably the (B/A)×100≥100% is true, where A denotes a tack force (gf) of the surface of the thermal conductive sheet immediately after the release films are peeled off subsequent to the press processing of the (1) and B denotes a tack force (gf) of the surface of the thermal conductive sheet when the thermal conductive sheet is indented by 50 pm at 2 mm/second with a probe having a diameter of 5.1 mm and the probe is pulled away at 10 mm/second after exposure to atmosphere for 1 hour subsequent to the press processing of the thermal conductive sheet. (Hereinafter, the obtained value will also be referred to as a retention rate of a tack force after exposure to the atmosphere.)
(3) The tack force of the surface of the thermal conductive sheet is 20 gf or lower, preferably 15 gf or lower, where the tack force is determined when immediately after a slice processing of the thermal conductive sheet, the thermal conductive sheet is indented by 50 pm at 2 mm/second with a probe having a diameter of 5.1 mm and the probe is pulled away at 10 mm/second.

The tack force in the above (1) to (3) is a value measured using, for example, a tackiness tester obtained from Malcom Co., Ltd. in the DEPTH mode. Specifically, it is a tack force of the surface of the thermal conductive sheet when the thermal conductive sheet is indented by 50 pm at 2 mm/second with a probe having a diameter of 5.1 mm and the probe is pulled away at 10 mm/second.

The "immediately after the release films are peeled off" in the above (1) and (2) means 3 minutes or shorter from peeling off of the release films.

The release films are preferably those that subjected to a release treatment with, for example, wax.

The "exposure to atmosphere for 1 hour" in the above (2) means exposure to the atmosphere of 25°C in temperature.

The "immediately after a slice processing" in the above (3) means 5 minutes or shorter from the slice processing of the thermal conductive sheet.

The Shore OO hardness of the thermal conductive sheet is preferably 40 or more but 70 or less and more preferably 45 or more but 60 or less.

When the Shore OO hardness is 40 or more but 70 or less, the thermal conductive sheet has enough flexibility and becomes favorable in followability and close adhesiveness to the surface of an electronic parts and a heat spreader.

The Shore OO hardness can be measured using, for example, a Shore OO durometer according to ASTM-D2240.

### <Carbon fiber>

The carbon fiber is not particularly limited and may be appropriately selected depending on the intended purpose. Examples thereof include a pitch-based carbon fiber, a PAN-based carbon fiber, a carbon fiber obtained by graphitizing a PBO fiber, and carbon fibers synthesized by, for example, the arc discharge method, the laser evaporation method, the CVD method (chemical vapor deposition), and the CCVD method (catalytic chemical vapor deposition. These may be used alone or in combination. Of these, in terms of thermal conductivity, a carbon fiber obtained by graphitizing a PBO fiber, a PAN-based carbon fiber, and a pitch-based carbon fiber are preferable, and a pitch-based carbon fiber is particularly preferable.

The average fiber diameter (average minor axis length) of the carbon fiber is not particularly limited and may be appropriately selected depending on the intended purpose. It is preferably 4 pm or more but 20 pm or less and more preferably 5 pm or more but 14 pm or less.

The average fiber length (average major axis length) of the carbon fiber is not particularly limited and may be appropriately selected depending on the intended purpose. It is preferably 50 pm or more but 250 pm or less, more preferably 75 pm or more but 200 pm or less, and particularly preferably 90 pm or more but 170 pm or less.

The thermal conductivity of the carbon fiber itself is appropriately selected depending on the desired thermal conductivity of the thermal conductive sheet to be formed. It is preferably 150 W/m·K or higher but 1000 W/m·K or lower.

The amount of the carbon fiber in the thermal conductive sheet is preferably 15% by volume or more but 30% by volume or less. This is because too small an amount thereof may lead to low thermal conductivity, while too large an amount thereof may lead to high viscosity.

### <Inorganic filler other than the carbon fiber>

The inorganic filler other than the carbon fiber preferably contains at least one selected from: aluminum oxide having a specific surface area of 1.4 m²/g or more; aluminum nitride having a specific surface area of 1.4 m²/g or more; and aluminum hydroxide. More preferably, it contains aluminum oxide or aluminum nitride, and aluminum hydroxide.

Some thermal conductive sheets in the art develop tack property after taken from molds to undergo a slice/press processing. However, exposure of the sheets to the air results in decrease in tack force over time.

In the present invention, by incorporating as the inorganic filler other than the carbon fiber, at least one selected from: aluminum oxide having a specific surface area of 1.4 m²/g or more; aluminum nitride having a specific surface area of 1.4 m²/g or more; and aluminum hydroxide, the resultant thermal conductive sheet does not develop tack property at the time of a slice processing and does develop strong tack property only when the surface of the thermal conductive sheet becomes smooth by a press processing. This is why handling property is favorable and enough tack property can be retained later on.

The specific surface area of aluminum oxide or aluminum nitride is preferably 1.4 m²/g or more and more preferably 1.4 m²/g or more but 3.3 m²/g or less. When the specific surface area is 1.4 m²/g or more, there is an advantage that the surface state of the thermal conductive sheet after a press processing can be allowed to be smoother.

The specific surface area can be measured by, for example, the BET method.

The shape, volume average particle diameter, etc. of the inorganic filler other than the carbon fiber are not particularly limited and may be appropriately selected depending on the intended purpose. The shape thereof is not particularly limited and may be appropriately selected depending on the intended purpose. Examples of the shape include a spherical shape, an ellipsoidal shape, a block shape, a grainy shape, a flat shape, and an acicular shape. Of these, a spherical shape and an ellipsoidal shape are preferable in terms of fillability, and a spherical shape is particularly preferable.

The volume average particle diameter of the inorganic filler other than the carbon fiber is preferably 0.4 pm or more but 2 pm or less and more preferably 0.7 pm or more but 2 pm or less. When the volume average particle diameter is 0.4 pm or more but 2 pm or less, there is an advantage that the filler in the thermal conductive sheet becomes denser to improve the tack retention ability of the sheet.

The volume average particle diameter can be measured with, for example, a particle size distribution analyzer based on the laser diffraction/scattering method.

The inorganic filler other than the carbon fiber may be subjected to a surface treatment. The surface treatment (e.g., a coupling treatment) is not particularly limited and may be appropriately selected depending on the intended purpose. For example, the inorganic filler other than the carbon fiber is preferably treated with an alkoxysilane compound.

The amount of the alkoxysilane compound used for the treatment is preferably 0.1% by volume or more but 4.0% by volume or less and more preferably 1.5% by volume or more but 3.0% by volume or less, relative to the inorganic filler other than the carbon fiber.

The alkoxysilane compound is a compound having a structure where one to three bonds of the four bonds which a silicon atom (Si) has are bonded to an alkoxy group, and the rest bond(s) is(are) bonded to an organic substituent. Examples of the alkoxy group in the alkoxysilane compound include a methoxy group, an ethoxy group, a protoxy group, a butoxy group, a pentoxy group, and a hexatoxy group. The alkoxysilane compound may be contained as a dimer in the thermal conductive sheet.

Of the alkoxysilane compound, in terms of easiness to obtain, an alkoxysilane compound having a methoxy group or an ethoxy group is preferable. The number of alkoxy groups in the alkoxysilane compound is preferably three from the viewpoint of increasing affinity to thermal conductive filler as an inorganic material. The alkoxysilane compound is more preferably at least one selected from a trimethoxysilane compound and a triethoxysilane compound.

Examples of a functional group contained in the organic substituent which the alkoxysilane compound has include an acryloyl group, an alkyl group, a carboxyl group, a vinyl group, a methacryl group, an aromatic group, an amino group, an isocyanate group, an isocyanurate group, an epoxy group, a hydroxyl group, and a mercapto group. When addition-reactive organopolysiloxane containing a platinum catalyst is used as a precursor of the matrix, it is preferable to select and use such an alkoxysilane compound that does not easily affect the curing reaction of organopolysiloxane. Specifically, in the case of using the addition reaction-type organopolysiloxane containing a platinum catalyst, the organic substituent in the alkoxysilane compound is preferably free of an amino group, an isocyanate group, an isocyanurate group, a hydroxyl group, or a mercapto group.

The alkoxysilane compound increases dispersibility of the inorganic filler other than the carbon fiber to make it easier to densely pack the inorganic filler other than the carbon fiber. Therefore, it is preferably to contain an alkylalkoxysilane compound having an alkyl group bonded to a silicon atom; i.e., an alkoxysilane compound having an alkyl group as the organic substituent. The number of carbon atoms of the alkyl group bonded to the silicon atom is preferably four or more. Also, the number of carbon atoms of the alkyl group bonded to the silicon atom is preferably 16 or less because the alkoxysilane compound itself has relatively low viscosity and makes the viscosity of the resin composition low.

The alkoxysilane compound may be used alone or in combination.

Specific examples of the alkoxysilane compound include an alkyl group-containing alkoxysilane compound, a vinyl group-containing alkoxysilane compound, an acryloyl group-containing alkoxysilane compound, a methacryloylgroup-containing alkoxysilane compound, an aromatic group-containing alkoxysilane compound, an amino group-containing alkoxysilane compound, an isocyanate group-containing alkoxysilane compound, an isocyanurate group-containing alkoxysilane compound, an epoxy group-containing alkoxysilane compound, and a mercapto group-containing alkoxysilane compound.

Examples of the alkyl group-containing alkoxysilane compound include methyltrimethoxysilane, dimethyldimethoxysilane, trimethylmethoxysilane, methyltriethoxysilane, dimethyldiethoxysilane, ethyltrimethoxysilane, n-propyltrimethoxysilane, n-propyltriethoxysilane, isobutyltrimethoxysilane, isobutyltriethoxysilane, n-hexyltrimethoxysilane, n-hexyltriethoxysilane, cyclohexylmethyldimethoxysilane, n-octyltriethoxysilane, and n-decyltrimethoxysilane. Of the alkyl group-containing alkoxysilane compound, at least one selected from isobutyltrimethoxysilane, isobutyltriethoxysilane, n-hexyltrimethoxysilane, n-hexyltriethoxysilane, cyclohexylmethyldimethoxysilane, n-octyltriethoxysilane, and n-decyltrimethoxysilane is preferable.

Examples of the vinyl group-containing alkoxysilane compound include vinyltrimethoxysilane and vinyltriethoxysilane. Examples of the acryloyl group-containing alkoxysilane compound include 3-acryloxypropyltrimethoxysilane. Examples of the methacryl group-containing alkoxysilane compound include 3-methacryloxypropylmethyldimethoxysilane, 3-methacryloxypropyltrimethoxysilane, and 3-methacryloxypropyltriethoxysilane. Examples of the aromatic group-containing alkoxysilane compound include phenyltrimethoxysilane and phenyltriethoxysilane. Examples of the amino group-containing alkoxysilane compound include N-2-(aminoethyl)-3-aminopropylmethyldimethoxysilane, N-2-(aminoethyl)-3-aminopropyltrimethoxysilane, 3-aminopropyltrimethoxysilane, 3-aminopropyltriethoxysilane, and N-phenyl-3-aminopropyltrimethoxysilane. Examples of the isocyanate group-containing alkoxysilane compound include 3-isocyanatepropyltriethoxysilane. Examples of the isocyanurate group-containing alkoxysilane compound include tris-(trimethoxysilylpropyl)isocyanurate. Examples of the epoxy group-containing alkoxysilane compound include 2-(3,4-epoxycyclohexyl)ethyltrimethoxysilane, 3-glycidoxypropylmethyldimethoxysilane, 3-glycidoxypropyltrimethoxysilane, and 3-glycidoxypropyltriethoxysilane. Examples of the mercapto group-containing alkoxysilane compound include 3-mercaptopropyltrimethoxysilane.

The amount of the inorganic filler other than the carbon fiber is not particularly limited and may be appropriately selected depending on the intended purpose. It is preferably 40% by volume or more but 80% by volume or less and more preferably 45% by volume or more but 75% by volume or less. When the amount thereof is less than 40% by volume, the resultant thermal conductive sheet may have higher heat resistance. When it is more than 80% by volume, the resultant thermal conductive sheet may have lowered flexibility.

### <Binder resin>

The binder resin is not particularly limited and may be appropriately selected depending on the intended purpose. Examples thereof include a thermoplastic resin, a thermoplastic elastomer, and a thermosetting polymer.

Examples of the thermoplastic resin include: polyethylene, polypropylene, ethylene-a olefin copolymers such as an ethylene-propylene copolymer; polymethylpentene, polyvinyl chloride, polyvinylidene chloride, polyvinyl acetate, an ethylene-vinyl acetate copolymer, polyvinyl alcohol, polyvinyl acetal, fluorine-based polymers such as polyvinylidene fluoride and polytetrafluoroethylene; polyethylene terephthalate, polybutylene terephthalate, polyethylene naphthalate, polystyrene, polyacrylonitrile, a styrene-acrylonitrile copolymer, an acrylonitrile-butadiene-styrene copolymer (ABS) resin, a polyphenylene-ether copolymer (PPE) resin, a modified PPE resin, aliphatic polyamides, aromatic polyamides, polyimide, polyamideimide, polymethacrylic acid, polymethacrylic acid esters such as polymethacrylic acid methyl ester; polyacrylic acids, polycarbonate, polyphenylenesulfide, polysulfone, polyethersulfone, polyethernitrile, polyether ketone, polyketone, liquid crystal polymers, a silicone resin, and an ionomer. These may be used alone or in combination.

Examples of the thermoplastic elastomer include a styrene-butadiene block copolymer or a hydrogenated product thereof, a styrene-isoprene block copolymer or a hydrogenated product thereof, a styrene-based thermoplastic elastomer, an olefin-based thermoplastic elastomer, a vinyl chloride-based thermoplastic elastomer, a polyester-based thermoplastic elastomer, a polyurethane-based thermoplastic elastomer, and a polyamide-based thermoplastic elastomer. These may be used alone or in combination.

Examples of the thermosetting polymer include cross-linked rubber, an epoxy resin, a polyimide resin, a bismaleimide resin, a benzocyclobutene resin, a phenol resin, unsaturated polyester, a diallyl phthalate resin, a silicone resin, polyurethane, polyimide silicone, thermosetting polyphenylene ether, and thermosetting modified polyphenylene ether. These may be used alone or in combination.

Examples of the cross-linked rubber include natural rubber, butadiene rubber, isoprene rubber, nitrile rubber, hydrogenated nitrile rubber, chloroprene rubber, ethylene propylene rubber, chlorinated polyethylene, chlorosulfonated polyethylene, butyl rubber, halogenated butyl rubber, fluororubber, urethane rubber, acrylic rubber, polyisobutylene rubber, and silicone rubber. These may be used alone or in combination.

Of these, a silicone resin is particularly preferable as the binder resin, because of an excellent molding processability and an excellent weatherability and in terms of close adhesiveness and followability to an electronic part.

The silicone resin is not particularly limited and may be appropriately selected depending on the intended purpose. It is preferable that the silicone resin contain a main agent formed of a liquid silicone gel, and a curing agent. Examples of such a silicone resin include an addition-reactive silicone resin and a thermally-vulcanizable millable silicone resin to be vulcanized with peroxides. Of these, an addition-reactive silicone resin is particularly preferable because the thermal conductive sheet needs to have close adhesiveness to a heat generating surface of an electronic part and a heat sink surface.

As the addition-reactive silicone resin, a two-pack addition-reactive silicone resin containing vinyl group-containing polyorganosiloxane as a main agent and Si-H group-containing polyorganosiloxane as a curing agent is preferable.

The blending ratio between the main agent and the curing agent in the combination of the liquid silicone gel main agent and the curing agent is not particularly limited and may be appropriately selected depending on the intended purpose.

The amount of the binder resin is not particularly limited and may be appropriately selected depending on the intended purpose. It is preferably 25% by volume or more 56% by volume or less and more preferably 25% by volume or more 40% by volume or less, relative to the total amount of the resin composition.

### <Other components>

The other components are not particularly limited and may be appropriately selected depending on the intended purpose. Examples of the other components include a thixotropic nature imparting agent, a dispersant, a curing accelerator, a retarder, a slight adhesiveness imparting agent, a plasticizer, a flame retardant, an antioxidant, a stabilizer, and a colorant.

### (Method for producing thermal conductive sheet)

A method of the present invention for producing a thermal conductive sheet includes a molded body producing step and a molded body sheet producing step, preferably includes a resin composition preparing step and a pressing step, and if necessary, further includes other steps.

The method for producing the thermal conductive sheet is a method for producing the thermal conductive sheet of the present invention.

According to the method of the present invention for producing the thermal conductive sheet, strong tackiness is imparted to the surface of the thermal conductive sheet, and thus there is no need to use an adhesive separately. This can realize energy saving in the production steps and cost reduction.

### <Resin composition preparing step>

The resin composition preparing step is a step of kneading a binder resin, a carbon fiber, and an inorganic filler other than the carbon fiber, to obtain a resin composition.

Examples of the binder resin include the binder resins exemplified in the description of the thermal conductive sheet.

Examples of the carbon fiber include the carbon fibers exemplified in the description of the thermal conductive sheet.

Examples of the inorganic filler other than the carbon fiber include the inorganic fillers other than the carbon fiber exemplified in the description of the thermal conductive sheet.

A method of the kneading is not particularly limited and may be appropriately selected depending on the intended purpose

### <Molded body producing step>

The molded body producing step is a step of molding the resin composition into a predetermined shape, followed by curing, to obtain a molded body of the resin composition

A method for molding the resin composition into a predetermined shape in the molded body producing step is not particularly limited and may be appropriately selected depending on the intended purpose. Examples thereof include an extrusion molding method and a die molding method.

The extrusion molding method and the die molding method are not particularly limited and may be appropriately employed from various types of known extrusion molding methods and die molding methods depending on, for example, the viscosity of the resin composition and the properties required for a thermal conductive sheet to be obtained.

The size and shape of the molded body (a block-shaped molded body) can be determined depending on the required size of the thermal conductive sheet. Examples of the size and shape include a rectangular parallelepiped having a cross-section in which the vertical size is 0.5 cm or longer but 15 cm or shorter and the horizontal size is 0.5 cm or longer but 15 cm or shorter. The length of the rectangular parallelepiped may be determined according to necessity.

Curing of the resin composition in the molded body producing step is preferably thermal curing. The curing temperature in the thermal curing is not particularly limited, may be appropriately selected depending on the intended purpose, and is preferably 60°C or higher but 120°C or lower when, for example, the binder resin contains a liquid silicone gel main agent and a curing agent. The curing time in the thermal curing is not particularly limited, may be appropriately selected depending on the intended purpose, and is, for example, 0.5 hours or longer but 10 hours or shorter.

### <Molded body sheet producing step>

The molded body sheet producing step is a step of cutting the molded body into a sheet to obtain a molded body sheet. The molded body sheet producing step can be performed with, for example, a slicing device.

The slicing device is not particularly limited and may be appropriately selected depending on the intended purpose. Examples thereof include an ultrasonic cutter and a plane. The cutting direction along which the molded body is cut is preferably 60 degrees or greater but 120 degrees or less, more preferably 70 degrees or greater but 100 degrees or less, and particularly preferably 90 degrees (vertically) with respect to the extruding direction because there are components that are oriented along the extruding direction when the molding method is the extrusion molding method.

The average thickness of the molded body sheet is not particularly limited, may be appropriately selected depending on the intended purpose. It is preferably 0.1 mm or greater but 5.0 mm or less and more preferably 0.2 mm or greater but 1.0 mm or less.

### <Press step>

The press step is a step of subjecting the molded body sheet to a press processing.

The press can be performed with, for example, a pair of press devices formed of a platen and a press head having a flat surface. The press may also be performed with a pinch roll.

The press pressure is not particularly limited, may be appropriately selected depending on the intended purpose, and is preferably 0.1 MPa or higher but 100 MPa or lower and more preferably 0.5 MPa or higher but 95 MPa or lower. This is because when the pressure is too low, thermal resistance may result in the same level as when the press is not performed, and because when the pressure is too high, the sheet may be elongated.

The press time is not particularly limited and may be appropriately selected depending on, for example, the component of the binder resin, the press pressure, the area of the sheet, and the bleeding amount of the bled-out component.

In order to even more promote the effects of bleeding of the bled-out component, the press processing may be performed under heating using a press head including a built-in heater. In order to enhance these effects, the heating temperature is preferably higher than or equal to the glass transition temperature of the binder resin. This can shorten the press time.

In the press processing, the molded body sheet is pressed in order to cause the bled-out component to bleed out from the molded body sheet and coat the surface with the bled-out component. Therefore, the thermal conductive sheet to be obtained can have an improved followability and an improved close adhesiveness to the surface of an electronic part and of a heat spreader and can have a lower thermal resistance.

With the press, the molded body sheet is compressed in the thickness direction and can be increased in the frequency of mutual contacts of the carbon fiber and of the inorganic filler other than the carbon fiber. This can reduce the thermal resistance of the thermal conductive sheet.

It is preferable to perform the press processing with the use of a spacer for compressing the molded body sheet to have a predetermined thickness. That is, for example, by the molded body sheet being pressed with the spacer placed on a placing surface that faces the press head, the thermal conductive sheet can be formed to have a predetermined sheet thickness corresponding to the height of the spacer.

### <Other steps>

Examples of the other steps include a molded body sheet leaving step.

The molded body sheet leaving step is not particularly limited and may be appropriately selected depending on the intended purpose as long as it is a step of leaving the molded body sheet standing to let the surface of the molded body sheet be coated with the bled-out component that has bled out from the molded body sheet.

The treatment for coating the surface of the molded body sheet with the bled-out component of the binder resin that has bled out from the molded body sheet may be the molded body sheet leaving step, instead of the press step. Also in this case, the thermal conductive sheet to be obtained can have an improved followability and an improved close adhesiveness to the surface of an electronic part and of a heat spreader and can have a lower thermal resistance, as in the case of the press step.

The standing time is not particularly limited and may be appropriately selected depending on the intended purpose.

The average thickness of the thermal conductive sheet is not particularly limited and may be appropriately selected depending on the intended purpose. It is preferably 0.05 mm or greater but 5.00 mm or less and more preferably 0.10 mm or greater but 3.00 mm or less.

The volume resistivity of the thermal conductive sheet at an applied voltage of 1,000 V is preferably 1.0×10¹⁰ Ω·cm or higher in terms of preventing short-circuiting of an electronic circuit located around the semiconductor element used. The volume resistivity is measured according to, for example, JIS K-6911.

The upper limit of the volume resistivity is not particularly limited and may be appropriately selected depending on the intended purpose. For example, the volume resistivity may be 1.0×10¹⁸ Ω·cm or lower.

The compressibility of the thermal conductive sheet at a load of 0.5 kgf/cm² is preferably 3% or higher and more preferably 5% or higher in terms of close adhesiveness to an electronic part and a heat sink.

The upper limit of the compressibility of the thermal conductive sheet is not particularly limited and may be appropriately selected depending on the intended purpose. The compressibility of the thermal conductive sheet is preferably 30% or lower.

### (Heat dissipation structure)

The heat dissipation structure of the present invention is composed of a heat generator, a thermal conductive sheet, and a heat dissipation member.

The heat dissipation structure is composed, for example, of: a heat generator such as an electronic part; a heat dissipation member such as a heat sink, a heat pipe, and a heat spreader; and a thermal conductive sheet held between the heat generator and the heat dissipation member.

The electronic part is not particularly limited and may be appropriately selected depending on the intended purpose. Examples thereof include CPU (Central Processing Unit), MPU (Micro Processing Unit), and GPU (Graphics Processing Unit).

The heat dissipation structure is not particularly limited and may be appropriately selected depending on the intended purpose as long as it is a structure configured to dissipate heat generated by an electronic part (heat generator). Examples of the heat dissipation structure include a heat spreader, a heat sink, a vapor chamber, and a heat pipe.

The heat spreader is a member configured to efficiently transfer heat of the electronic part to another part. The material of the heat spreader is not particularly limited and may be appropriately selected depending on the intended purpose. Examples thereof include copper and aluminum. The heat spreader typically has a shape of plate.

The heat sink is a member configured to release heat of the electronic part to the air. The material of the heat sink is not particularly limited and may be appropriately selected depending on the intended purpose. Examples thereof include copper and aluminum. For example, the heat sink has a plurality of fins. Specifically, the heat sink has a base part and a plurality of fins that are provided to extend toward one surface of the base in a non-parallel direction (e.g., a perpendicular direction).

The heat spreader and the heat sink are typically solid structures having no space therein.

The vapor chamber is a hollow structure. Volatile liquid is enclosed in the internal space of the hollow structure. Examples of the vapor chamber include the heat spreader modified to have a hollow structure and a plate-shaped hollow structure obtained by modifying the heat sink to have a hollow structure.

The heat pipe is a cylindrical, generally cylindrical, or flat cylindrical hollow structure. Volatile liquid is enclosed in the internal space of the hollow structure.

FIG. 1 is a schematic view of a semiconductor device as one example of the heat dissipation structure of the present invention. FIG. 1 is a schematic cross-sectional view of one example of the semiconductor device. A thermal conductive sheet 1 of the present invention is configured to dissipate heat generated by an electronic part 3 such as a semiconductor element, and as illustrated in FIG. 1, is fixed on a principal surface 2a of a heat spreader 2 facing the electronic part 3 and interposed between the electronic part 3 and the heat spreader 2. The thermal conductive sheet 1 is also interposed between the heat spreader 2 and a heat sink 5. Together with the heat spreader 2, the thermal conductive sheet 1 constitutes a heat dissipation member configured to dissipate heat of the electronic part 3.

The heat spreader 2 is formed in, for example, a square plate shape, and includes the principal surface 2a facing the electronic part 3 and a side wall 2b formed upright along the periphery of the principal surface 2a. In the heat spreader 2, the thermal conductive sheet 1 is provided on the principal surface 2a surrounded by the side wall 2b, and the heat sink 5 is provided on the other surface 2c opposite to the principal surface 2a with the thermal conductive sheet 1 interposed between the heat sink and the other surface. The head spreader 2 may be formed of, for example, copper or aluminum having a good thermal conductivity, because a higher thermal conductivity ensures a lower thermal resistance and a more efficient absorption of heat from the electronic part 3 such as a semiconductor element.

The electronic part 3 is, for example, a semiconductor element such as BGA, and is mounted on a wiring board 6. The end surface of the side wall 2b of the heat spreader 2 is also mounted on the wiring board 6. In this way, the electronic part 3 is surrounded by the side wall 2b with a predetermined distance secured.

Then, with the thermal conductive sheet 1 bonded to the principal surface 2a of the heat spreader 2, a heat dissipation member configured to absorb heat generated by the electronic part 3 and dissipate the heat through the heat sink 5 is formed. The heat spreader 2 and the thermal conductive sheet 1 may be bonded to each other by the own adhesive force of the thermal conductive sheet 1.

### (Electronic device)

The electronic device of the present invention includes the heat dissipation structure of the present invention.

One example of the electronic device is a semiconductor device using a semiconductor element as an electronic part.

### Examples

The present invention will be described below by way of Examples. The present invention should not be construed as being limited to these Examples.

### (Example 1)

### -Production of thermal conductive sheet-

In Example 1, aluminum hydroxide particles having a volume average particle diameter of 1 pm (thermal conductive particles, obtained from Nippon Light Metal Company, Ltd.) (44% by volume), which had been subjected to a coupling treatment with a coupling agent (0.3% by volume as an amount used for the treatment), and pitch-based carbon fibers (thermal conductive fibers, average fiber length: 120 µm, average fiber diameter: 9 µm, obtained from Nippon Graphite Fiber Co., Ltd.) (21% by volume) were dispersed in a two-pack addition-reactive liquid silicone resin (34.7% by volume) to prepare a silicone resin composition (thermal conductive resin composition).

The two-pack addition-reactive liquid silicone resin is a mixture containing Silicone A liquid at 20.7% by volume and Silicone B liquid at 14% by volume.

The obtained silicone resin composition was extruded into a rectangular-parallelepiped die (50 mm × 50 mm) having a releasably-treated polyethylene terephthalate (PET) film pasted on the internal wall, to mold a silicone molded body.

The obtained silicone molded body was cured in an oven at 100°C for 6 hours, to obtain a silicone cured product. The obtained silicone cured product was cut with an ultrasonic cutter, to obtain a molded body sheet having a thickness of 0.43 mm. The slicing speed of the ultrasonic cutter was set to 50 mm per second. Ultrasonic vibration to be applied to the ultrasonic cutter was set to an oscillation frequency of 20.5 kHz and an amplitude of 60 pm.

The obtained molded body sheet was sandwiched between releasably-treated PET films, and pressed with a spacer having a thickness of 0.4 mm inserted, to obtain a thermal conductive sheet having a thickness of 0.40 mm. The press conditions were 87°C, 0.5 MPa, and 30 seconds.

### (Example 2)

### -Production of thermal conductive sheet-

In Example 2, aluminum hydroxide particles having a volume average particle diameter of 1 pm (thermal conductive particles, obtained from Nippon Light Metal Company, Ltd.) (44% by volume), which had been subjected to a coupling treatment with a coupling agent (0.3% by volume as an amount used for the treatment), and pitch-based carbon fibers (thermal conductive fibers, average fiber length: 120 µm, average fiber diameter: 9 µm, obtained from Nippon Graphite Fiber Co., Ltd.) (21% by volume) were dispersed in a two-pack addition-reactive liquid silicone resin (34.7% by volume) to prepare a silicone resin composition (thermal conductive resin composition).

The two-pack addition-reactive liquid silicone resin is a mixture containing Silicone A liquid at 20.7% by volume and Silicone B liquid at 14% by volume.

The obtained silicone resin composition was extruded into a rectangular-parallelepiped die (50 mm × 50 mm) having a releasably-treated polyethylene terephthalate (PET) film pasted on the internal wall, to mold a silicone molded body.

The obtained silicone molded body was cured in an oven at 100°C for 6 hours, to obtain a silicone cured product. The obtained silicone cured product was cut with an ultrasonic cutter, to obtain a molded body sheet having a thickness of 0.43 mm. The slicing speed of the ultrasonic cutter was set to 50 mm per second. Ultrasonic vibration to be applied to the ultrasonic cutter was set to an oscillation frequency of 20.5 kHz and an amplitude of 60 pm.

The obtained molded body sheet was sandwiched between releasably-treated PET films, and pressed with a spacer having a thickness of 0.4 mm inserted, to obtain a thermal conductive sheet having a thickness of 0.40 mm. The press conditions were 25°C, 0.5 MPa, and 30 seconds.

### (Example 3)

### -Production of thermal conductive sheet-

In Example 3, aluminum hydroxide particles having a volume average particle diameter of 1 pm (thermal conductive particles, obtained from Nippon Light Metal Company, Ltd.) (44% by volume), which had been subjected to a coupling treatment with a coupling agent (0.3% by volume as an amount used for the treatment), and pitch-based carbon fibers (thermal conductive fibers, average fiber length: 120 µm, average fiber diameter: 9 µm, obtained from Nippon Graphite Fiber Co., Ltd.) (21% by volume) were dispersed in a two-pack addition-reactive liquid silicone resin (34.7% by volume) to prepare a silicone resin composition (thermal conductive resin composition).

The two-pack addition-reactive liquid silicone resin is a mixture containing Silicone A liquid at 20.7% by volume and Silicone B liquid at 14% by volume.

The obtained silicone resin composition was extruded into a rectangular-parallelepiped die (50 mm × 50 mm) having a releasably-treated polyethylene terephthalate (PET) film pasted on the internal wall, to mold a silicone molded body.

The obtained silicone molded body was cured in an oven at 100°C for 6 hours, to obtain a silicone cured product. The obtained silicone cured product was cut with an ultrasonic cutter, to obtain a molded body sheet having a thickness of 0.43 mm. The slicing speed of the ultrasonic cutter was set to 50 mm per second. Ultrasonic vibration to be applied to the ultrasonic cutter was set to an oscillation frequency of 20.5 kHz and an amplitude of 60 pm.

The obtained molded body sheet was sandwiched between releasably-treated PET films, and pressed with a spacer having a thickness of 0.4 mm inserted, to obtain a thermal conductive sheet having a thickness of 0.40 mm. The press conditions were 100°C, 0.5 MPa, and 30 seconds.

### (Example 4)

### -Production of thermal conductive sheet-

A thermal conductive sheet of Example 4 was produced in the same manner as in Example 1 except that aluminum oxide particles having a volume average particle diameter of 1 pm (specific surface area: 3.3 m²/g, thermal conductive particles, obtained from Nippon Light Metal Company, Ltd.) (36% by volume), which had been subjected to a coupling treatment with a coupling agent (0.7% by volume as an amount used for the treatment), aluminum hydroxide particles having a volume average particle diameter of 1 pm (thermal conductive particles, obtained from Nippon Light Metal Company, Ltd.) (10% by volume), which had been subjected to a coupling treatment with a coupling agent (0.2% by volume as an amount used for the treatment), and pitch-based carbon fibers (thermal conductive fibers, average fiber length: 120 µm, average fiber diameter: 9 µm, obtained from Nippon Graphite Fiber Co., Ltd.) (20% by volume) were dispersed in a two-pack addition-reactive liquid silicone resin (33.1% by volume) to prepare a silicone resin composition (thermal conductive resin composition).

The two-pack addition-reactive liquid silicone resin is a mixture containing Silicone A liquid at 19.1% by volume and Silicone B liquid at 14% by volume. The specific surface area of the aluminum oxide particles is a value measured by the BET method.

### (Example 5)

### -Production of thermal conductive sheet-

A thermal conductive sheet of Example 5 was produced in the same manner as in Example 1 except that aluminum oxide particles having a volume average particle diameter of 1 pm (specific surface area: 3.3 m²/g, thermal conductive particles, obtained from Nippon Light Metal Company, Ltd.) (34% by volume), which had been subjected to a coupling treatment with a coupling agent (0.2% by volume as an amount used for the treatment), aluminum hydroxide particles having a volume average particle diameter of 1 pm (thermal conductive particles, obtained from Nippon Light Metal Company, Ltd.) (10% by volume), which had been subjected to a coupling treatment with a coupling agent (0.1% by volume as an amount used for the treatment), and pitch-based carbon fibers (thermal conductive fibers, average fiber length: 120 µm, average fiber diameter: 9 µm, obtained from Nippon Graphite Fiber Co., Ltd.) (21% by volume) were dispersed in a two-pack addition-reactive liquid silicone resin (34.7% by volume) to prepare a silicone resin composition (thermal conductive resin composition).

The two-pack addition-reactive liquid silicone resin is a mixture containing Silicone A liquid at 20.7% by volume and Silicone B liquid at 14% by volume. The specific surface area of the aluminum oxide particles is a value measured by the BET method.

### (Example 6)

### -Production of thermal conductive sheet-

A thermal conductive sheet of Example 6 was produced in the same manner as in Example 1 except that aluminum oxide particles having a volume average particle diameter of 2 pm (specific surface area: 1.4 m²/g, thermal conductive particles, obtained from Nippon Light Metal Company, Ltd.) (38% by volume), which had been subjected to a coupling treatment with a coupling agent (0.7% by volume as an amount used for the treatment), aluminum hydroxide particles having a volume average particle diameter of 1 pm (thermal conductive particles, obtained from Nippon Light Metal Company, Ltd.) (10% by volume), which had been subjected to a coupling treatment with a coupling agent (0.2% by volume as an amount used for the treatment), and pitch-based carbon fibers (thermal conductive fibers, average fiber length: 120 µm, average fiber diameter: 9 µm, obtained from Nippon Graphite Fiber Co., Ltd.) (19% by volume) were dispersed in a two-pack addition-reactive liquid silicone resin (32.1% by volume) to prepare a silicone resin composition (thermal conductive resin composition).

The two-pack addition-reactive liquid silicone resin is a mixture containing Silicone A liquid at 19.1% by volume and Silicone B liquid at 13% by volume. The specific surface area of the aluminum oxide particles is a value measured by the BET method.

### (Example 7)

### -Production of thermal conductive sheet-

A thermal conductive sheet of Example 7 was produced in the same manner as in Example 1 except that aluminum oxide particles having a volume average particle diameter of 1 pm (specific surface area: 3.3 m²/g, thermal conductive particles, obtained from Nippon Light Metal Company, Ltd.) (44% by volume), which had been subjected to a coupling treatment with a coupling agent (0.3% by volume as an amount used for the treatment), and pitch-based carbon fibers (thermal conductive fibers, average fiber length: 120 µm, average fiber diameter: 9 µm, obtained from Nippon Graphite Fiber Co., Ltd.) (21% by volume) were dispersed in a two-pack addition-reactive liquid silicone resin (34.7% by volume) to prepare a silicone resin composition (thermal conductive resin composition).

The two-pack addition-reactive liquid silicone resin is a mixture containing Silicone A liquid at 20.7% by volume and Silicone B liquid at 14% by volume. The specific surface area of the aluminum oxide particles is a value measured by the BET method.

### (Example 8)

### -Production of thermal conductive sheet-

A thermal conductive sheet of Example 8 was produced in the same manner as in Example 1 except that aluminum nitride particles having a volume average particle diameter of 0.7 pm (specific surface area: 2.6 m²/g, thermal conductive particles, obtained from Tokuyama Corporation) (38% by volume), which had been subjected to a coupling treatment with a coupling agent (0.7% by volume as an amount used for the treatment), aluminum hydroxide particles having a volume average particle diameter of 1 pm (thermal conductive particles, obtained from Nippon Light Metal Company, Ltd.) (10% by volume), which had been subjected to a coupling treatment with a coupling agent (0.2% by volume as an amount used for the treatment), and pitch-based carbon fibers (thermal conductive fibers, average fiber length: 120 µm, average fiber diameter: 9 µm, obtained from Nippon Graphite Fiber Co., Ltd.) (19% by volume) were dispersed in a two-pack addition-reactive liquid silicone resin (32.1% by volume) to prepare a silicone resin composition (thermal conductive resin composition).

The two-pack addition-reactive liquid silicone resin is a mixture containing Silicone A liquid at 19.1% by volume and Silicone B liquid at 13% by volume. The specific surface area of the aluminum nitride particles is a value measured by the BET method.

### (Example 9)

### -Production of thermal conductive sheet-

A thermal conductive sheet of Example 9 was produced in the same manner as in Example 1 except that aluminum nitride particles having a volume average particle diameter of 0.7 pm (specific surface area: 2.6 m²/g, thermal conductive particles, obtained from Tokuyama Corporation) (44% by volume), which had been subjected to a coupling treatment with a coupling agent (0.3% by volume as an amount used for the treatment), and pitch-based carbon fibers (thermal conductive fibers, average fiber length: 120 µm, average fiber diameter: 9 µm, obtained from Nippon Graphite Fiber Co., Ltd.) (21% by volume) were dispersed in a two-pack addition-reactive liquid silicone resin (34.7% by volume) to prepare a silicone resin composition (thermal conductive resin composition).

The two-pack addition-reactive liquid silicone resin is a mixture containing Silicone A liquid at 20.7% by volume and Silicone B liquid at 14% by volume. The specific surface area of the aluminum nitride particles is a value measured by the BET method.

### (Example 10)

### -Production of thermal conductive sheet-

A thermal conductive sheet of Example 10 was produced in the same manner as in Example 1 except that aluminum oxide particles having a volume average particle diameter of 1 pm (specific surface area: 3.3 m²/g, thermal conductive particles, obtained from Nippon Light Metal Company, Ltd.) (38% by volume), which had been subjected to a coupling treatment with a coupling agent (0.7% by volume as an amount used for the treatment), aluminum hydroxide particles having a volume average particle diameter of 1 pm (thermal conductive particles, obtained from Nippon Light Metal Company, Ltd.) (10% by volume), which had been subjected to a coupling treatment with a coupling agent (0.2% by volume as an amount used for the treatment), and pitch-based carbon fibers (thermal conductive fibers, average fiber length: 120 µm, average fiber diameter: 9 µm, obtained from Nippon Graphite Fiber Co., Ltd.) (19% by volume) were dispersed in a two-pack addition-reactive liquid silicone resin (32.1% by volume) to prepare a silicone resin composition (thermal conductive resin composition).

The two-pack addition-reactive liquid silicone resin is a mixture containing Silicone A liquid at 18.1% by volume and Silicone B liquid at 14% by volume. The specific surface area of the aluminum oxide particles is a value measured by the BET method.

### (Comparative Example 1)

### -Production of thermal conductive sheet-

A thermal conductive sheet of Comparative Example 1 was produced in the same manner as in Example 1 except that aluminum oxide particles having a volume average particle diameter of 3 pm (specific surface area: 1 m²/g, thermal conductive particles, obtained from Denka Company Limited) (42% by volume), which had been subjected to a coupling treatment with a coupling agent (0.3% by volume as an amount used for the treatment), and pitch-based carbon fibers (thermal conductive fibers, average fiber length: 120 µm, average fiber diameter: 9 µm, obtained from Nippon Graphite Fiber Co., Ltd.) (23% by volume) were dispersed in a two-pack addition-reactive liquid silicone resin (34.7% by volume) to prepare a silicone resin composition (thermal conductive resin composition).

The two-pack addition-reactive liquid silicone resin is a mixture containing Silicone A liquid at 20.7% by volume and Silicone B liquid at 14% by volume. The specific surface area of the aluminum oxide particles is a value measured by the BET method.

### (Comparative Example 2)

### -Production of thermal conductive sheet-

A thermal conductive sheet of Comparative Example 2 was produced in the same manner as in Example 1 except that aluminum oxide particles having a volume average particle diameter of 1 pm (specific surface area: 1.1 m²/g, thermal conductive particles, obtained from Denka Company Limited) (42% by volume), which had been subjected to a coupling treatment with a coupling agent (0.3% by volume as an amount used for the treatment), and pitch-based carbon fibers (thermal conductive fibers, average fiber length: 120 µm, average fiber diameter: 9 µm, obtained from Nippon Graphite Fiber Co., Ltd.) (21% by volume) were dispersed in a two-pack addition-reactive liquid silicone resin (34.7% by volume) to prepare a silicone resin composition (thermal conductive resin composition).

The two-pack addition-reactive liquid silicone resin is a mixture containing Silicone A liquid at 20.7% by volume and Silicone B liquid at 14% by volume. The specific surface area of the aluminum oxide particles is a value measured by the BET method.

### <Measurement of thermal resistance>

The thermal conductive sheet, which had been deformed to have a diameter of 20 mm, was measured for thermal resistance (°C·cm²/W) by the method according to ASTM-D5470 at a load of 1 kgf/cm².

### <Measurement of Shore OO hardness>

Each thermal conductive sheet was measured for Shore OO hardness using a Shore OO durometer according to ASTM-D2240.

### <Measurement of tack force>

(1) A tack force of the surface of the thermal conductive sheet was determined when the thermal conductive sheet held between release films was subjected to a press processing at 0.5 MPa for 30 seconds, and immediately after the release films were peeled off (within 3 minutes thereafter), the thermal conductive sheet was indented by 50 pm at 2 mm/second with a probe having a diameter of 5.1 mm and the probe was pulled away at 10 mm/second.
(2) A value of (B/A)× 100 (a retention rate of a tack force after exposure to the atmosphere) was determined from A denoting a tack force (gf) of the surface of the thermal conductive sheet immediately after the release films were peeled off subsequent to the press processing of the (1) and B denoting a tack force (gf) of the surface of the thermal conductive sheet when the thermal conductive sheet was indented by 50 pm at 2 mm/second with a probe having a diameter of 5.1 mm and the probe was pulled away at 10 mm/second after exposure to the atmosphere 25°C in temperature for 1 hour subsequent to the press processing of the thermal conductive sheet.
(3) A tack force of the surface of the thermal conductive sheet was determined when immediately after a slice processing of the thermal conductive sheet (within 5 minutes thereafter), the thermal conductive sheet was indented by 50 pm at 2 mm/second with a probe having a diameter of 5.1 mm and the probe was pulled away at 10 mm/second.

The tack force in the above (1) to (3) is a value measured using a tackiness tester obtained from Malcom Co., Ltd. in the DEPTH mode. Specifically, it is a tack force of the surface of the thermal conductive sheet when the thermal conductive sheet was indented by 50 pm at 2 mm/second with a probe having a diameter of 5.1 mm and the probe was pulled away at 10 mm/second.

### <Evaluation of tack property to resist motions at the time of mounting>

Each thermal conductive sheet was placed on an aluminum (Al) plate and inverted to face downward without application of pressure. A retention time taken for the thermal conductive sheet to fall off from the Al plate was measured and evaluated according to the following criteria.

### [Evaluation criteria]

A: Retained for 300 seconds or longer.
B: Fell off at a point in time shorter than 300 seconds.

**Table 1**

| | | Ex. 1 | Ex. 2 | Ex. 3 | Ex. 4 | Ex. 5 | Ex. 6 |
|---|---|---|---|---|---|---|---|
| Silicone resin | Amount (% by vol.) | 34.7 | 34.7 | 34.7 | 33.1 | 34.7 | 32.1 |
| Carbon fibers | Amount (% by vol.) | 21 | 21 | 21 | 20 | 21 | 19 |
| Aluminum oxide | Amount (% by vol.) | 0 | 0 | 0 | 36 | 34 | 38 |
| | Specific surface area (m²/g) | - | - | - | 3.3 | 3.3 | 1.4 |
| | Vol. avg. particle diameter (*µ*m) | - | - | - | 1 | 1 | 2 |
| | Amount of coupling agent used for treatment (% by vol.) | - | - | - | 0.7 | 0.2 | 0.7 |
| Aluminum hydroxide | Amount (% by vol.) | 44 | 44 | 44 | 10 | 10 | 10 |
| | Vol. avg. particle diameter (*µ*m) | 1 | 1 | 1 | 1 | 1 | 1 |
| | Amount of coupling agent used for treatment (% by vol.) | 0.3 | 0.3 | 0.3 | 0.2 | 0.1 | 0.2 |
| Aluminum nitride | Amount (% by vol.) | 0 | 0 | 0 | 0 | 0 | 0 |
| | Specific surface area (m²/g) | - | - | - | - | - | - |
| | Vol. avg. particle diameter (*µ*m) | - | - | - | - | - | - |
| | Amount of coupling agent used for treatment (% by vol.) | - | - | - | - | - | - |
| Total amount of coupling agent used for treatment (% by vol.) | | 0.3 | 0.3 | 0.3 | 0.9 | 0.3 | 0.9 |
| Shore OO hardness | | 53 | 53 | 53 | 65 | 64 | 40 |
| Press temperature (°C) | | 87 | 25 | 100 | 87 | 87 | 87 |
| Avg. thiskness of sheet (mm) | | 0.4 | 0.4 | 0.4 | 0.42 | 0.42 | 0.43 |
| Thermal resistane of sheet (°C·cm²/W) | | 0.498 | 0.486 | 0.474 | 0.314 | 0.371 | 0.33 |
| (3) Tack force immediately after slice processing (gf) | | 9.3 | 9.3 | 9.3 | 12 | 9.2 | 7.6 |
| (1) Tack force after press processing: A (gf) | | 238 | 204 | 223 | 247 | 211 | 126 |
| Tack force when sheet was exposed to atmosphere for 1 hour: B (gf) | | 195 | 194 | 207 | 212 | 195 | 120 |
| (2) Retention rate of tack force after exposure to atmosphere (%): (B/A)× 100 | | 81.9 | 95.1 | 92.8 | 85.8 | 92.4 | 95.2 |
| Tack force resisting motions at the time of mounting | Evaluation results | A | A | A | A | A | A |
| | Mesurement results | Retained for 300 sec or longer | Retained for 300 sec or longer | Retained for 300 sec or longer | Retained for 300 sec or longer | Retained for 300 sec or longer | Retained for 300 sec or longer |

**Table 2**

| | | Ex. 7 | Ex. 8 | Ex. 9 | Ex. 10 | Comp. Ex. 1 | Comp. Ex. 2 |
|---|---|---|---|---|---|---|---|
| Silicone resin | Amount (% by vol.) | 34.7 | 32.1 | 34.7 | 32.1 | 34.7 | 34.7 |
| Carbon fibers | Amount (% by vol.) | 21 | 19 | 21 | 19 | 23 | 21 |
| Aluminum oxide | Amount (% by vol.) | 44 | 0 | 0 | 38 | 42 | 44 |
| | Specific surface area (m²/g) | 3.3 | - | - | 3.3 | 1 | 1.1 |
| | Vol. avg. particle diameter (*µ*m) | 1 | - | - | 1 | 3 | 1 |
| | Amount of coupling agent used for treatment (% by vol.) | 0.3 | - | - | 0.7 | 0.3 | 0.3 |
| Aluminum hydroxide | Amount (% by vol.) | 0 | 10 | 0 | 10 | 0 | 0 |
| | Vol. avg. particle diameter (*µ*m) | - | 1 | - | 1 | - | - |
| | Amount of coupling agent used for treatment (% by vol.) | - | 0.2 | - | 0.2 | - | - |
| Aluminum nitride | Amount (% by vol.) | 0 | 38 | 44 | 0 | 0 | 0 |
| | Specific surface area (m²/g) | - | 2.6 | 2.6 | - | - | - |
| | Vol. avg. particle diameter (*µ*m) | - | 0.7 | 0.7 | - | - | - |
| | Amount of coupling agent used for treatment (% by vol.) | - | 0.7 | 0.3 | - | - | - |
| Total amount of coupling agent used for treatment (% by vol.) | | 0.3 | 0.9 | 0.3 | 0.9 | 0.3 | 0.3 |
| Shore OO hardness | | 60 | 63 | 60 | 63 | 50 | 59 |
| Press temperature (°C) | | 87 | 87 | 87 | 87 | 87 | 87 |
| Avg. thiskness of sheet (mm) | | 0.5 | 0.4 | 0.4 | 0.41 | 0.42 | 0.4 |
| Thermal resistane of sheet (°C·cm²/W) | | 0.377 | 0.436 | 0.422 | 0.324 | 0.341 | 0.36 |
| (3) Tack force immediately after slice processing (gf) | | 18 | 6 | 8 | 14 | 2.8 | 1.5 |
| (1) Tack force after press processing: A (gf) | | 329 | 110 | 125 | 255 | 46 | 20 |
| Tack force when sheet was exposed to atmosphere for 1 hour: B (gf) | | 318 | 109 | 110 | 243 | 34 | 12 |
| (2) Retention rate of tack force after exposure to atmosphere (%): (B/A) × 100 | | 96.7 | 99.1 | 88 | 95.3 | 73.9 | 60 |
| Tack force resisting motions at the time of mounting | Evaluation results | A | A | A | A | B | B |
| | Mesurement results | Retained for 300 sec or longer | Retained for 300 sec or longer | Retained for 300 sec or longer | Retained for 300 sec or longer | Fell off 40 sec after | Fell off 10 sec after |

### Reference Signs List

- 1: thermal conductive sheet
- 2: heat dissipation member (heat spreader)
- 2a: principal surface
- 3: heat generator (electronic part)
- 3a: top surface
- 5: heat dissipation member (heat sink)
- 6: wiring board

## Claims

1. A thermal conductive sheet comprising
a cured product of a resin composition containing a carbon fiber, an inorganic filler other than the carbon fiber, and a binder resin,
wherein the thermal conductive sheet satisfies (1) and (2) below:
(1) a tack force of a surface of the thermal conductive sheet is 100 gf or greater, where the tack force is determined when the thermal conductive sheet held between release films is subjected to a press processing at 0.5 MPa for 30 seconds, and immediately after the release films are peeled off, the thermal conductive sheet is indented by 50 pm at 2 mm/second with a probe having a diameter of 5.1 mm and the probe is pulled away at 10 mm/second; and
(2) (B/A)× 100≥80% is true, where A denotes a tack force (gf) of the surface of the thermal conductive sheet immediately after the release films are peeled off subsequent to the press processing of the (1) and B denotes a tack force (gf) of the surface of the thermal conductive sheet when the thermal conductive sheet is indented by 50 pm at 2 mm/second with a probe having a diameter of 5.1 mm and the probe is pulled away at 10 mm/second after exposure to atmosphere for 1 hour subsequent to the press processing of the thermal conductive sheet.

2. The thermal conductive sheet according to claim 1, wherein the thermal conductive sheet further satisfies (3) the tack force of the surface of the thermal conductive sheet is 20 gf or lower, where the tack force is determined when immediately after a slice processing of the thermal conductive sheet, the thermal conductive sheet is indented by 50 pm at 2 mm/second with a probe having a diameter of 5.1 mm and the probe is pulled away at 10 mm/second.

3. The thermal conductive sheet according to claim 1 or 2, wherein the thermal conductive sheet has a Shore OO hardness of 40 or more but 70 or less.

4. The thermal conductive sheet according to any one of claims 1 to 3, wherein the inorganic filler other than the carbon fiber contains at least one selected from: aluminum oxide having a specific surface area of 1.4 m²/g or more; aluminum nitride having a specific surface area of 1.4 m²/g or more; and aluminum hydroxide.

5. The thermal conductive sheet according to any one of claims 1 to 4, wherein the inorganic filler other than the carbon fiber contains: aluminum oxide or aluminum nitride; and aluminum hydroxide.

6. The thermal conductive sheet according to claim 4 or 5, wherein the specific surface area of the aluminum oxide or the aluminum nitride is 1.4 m²/g or more but 3.3 m²/g or less.

7. The thermal conductive sheet according to any one of claims 1 to 6, wherein the inorganic filler other than the carbon fiber has a volume average particle diameter of 0.4 pm or more but 2 pm or less.

8. The thermal conductive sheet according to claim 7, wherein the inorganic filler other than the carbon fiber has a volume average particle diameter of 0.7 pm or more but 2 pm or less.

9. The thermal conductive sheet according to any one of claims 1 to 8, wherein the binder resin is a silicone resin.

10. A method for producing the thermal conductive sheet according to any one of claims 1 to 9, the method comprising:
molding the resin composition into a predetermined shape, followed by curing, to obtain a molded body of the resin composition, where the resin composition contains the binder resin, the carbon fiber, and the inorganic filler other than the carbon fiber; and
cutting the molded body into a sheet to obtain a molded body sheet.

11. A heat dissipation structure comprising:
a heat generator;
the thermal conductive sheet according to any one of claims 1 to 9; and
a heat dissipation member,
the heat generator, the thermal conductive sheet, and the heat dissipation member being provided in an order mentioned.

12. An electronic device comprising
the heat dissipation structure according to claim 11.
